(19) Europäisches Patentamt

European Patent Office

Office européen des brevets

(11) Veröffentlichungsnummer : **0 145 856**
**B1**

(12) **EUROPÄISCHE PATENTSCHRIFT**

(45) Veröffentlichungstag der Patentschrift :
11.11.87

(51) Int. Cl.⁴ : **G 01 D   5/26**

(21) Anmeldenummer : 84111038.0

(22) Anmeldetag : 15.09.84

(54) **Messgerät.**

(30) Priorität : 15.11.83 DE 3341265

(43) Veröffentlichungstag der Anmeldung :
26.06.85 Patentblatt 85/26

(45) Bekanntmachung des Hinweises auf die Patenterteilung : 11.11.87 Patentblatt 87/46

(84) Benannte Vertragsstaaten :
AT BE CH FR GB IT LI LU NL SE

(58) Entgegenhaltungen :
DD-A-   123 228
DE-A- 2 949 788
Die Akte enthält technische Angaben, die nach dem Eingang der Anmeldung eingereicht wurden und die nicht in dieser Patentschrift enthalten sind.

(73) Patentinhaber : Phönix Armaturen-Werke Bregel GmbH
Eschborner Landstrasse 41-51
D-6000 Frankfurt (DE)

(72) Erfinder : Omet, Reinhard, Dipl.-Phys.
Schwabenweg 1
D-6113 Babenhausen 1 (DE)
Erfinder : Kindsvater, Hans, Dipl.-Kaufmann
Theodor-Storm-Strasse 15
D-6390 Bad Homburg vdH. (DE)
Erfinder : Wall, Hans-Jürgen, Dipl.-Ing.
Viktoriastrasse 50 a
D-6100 Darmstadt (DE)

(74) Vertreter : Kratzsch, Volkhard, Dipl.-Ing.
Mülbergerstrasse 65
D-7300 Esslingen (DE)

EP 0 145 856 B1

## Beschreibung

Die Erfindung betrifft ein Meßgerät zum Messen physikalischer Größen, wie Längen, Winkel, Positionen, Temperatur, elektrischer Strom, Füllstand, der im Oberbegriff des Anspruchs 1 angegebenen Gattung.

Bei heute üblicherweise verwendeten Meßgeräten, wird die zu erfassende physikalische Meßgröße von dem Meßwertaufnehmer stets in eine elektrische Größe umgewandelt und erst die elektrische Größe der Anzeige zugeführt und dort sichtbar gemacht. Der hierfür erforderliche technische Aufwand ist nicht unbeträchtlich.

Bei anderen bekannten Meßgeräten erfolgt eine direkte Kopplung von mechanischen Anzeigeelementen an den Meßwertaufnehmer, so z. B. bei Füllstandmessern, bei welchen ein dauermagnetischer Schwimmer magnetische Anzeigeelemente in Feldrichtung ausrichtet. Solche mechanischen Lösungen erfordern eine aufwendige Fertigung, sind empfindlich gegen rauhe Betriebsbedingungen und haben nur ein begrenztes Auflösevermögen.

Aus der DD-A-123 228 ist eine Anordnung zum Einfangen von Strichmarken oder Kanten bekannt, bei welcher eine Polarisationsanordnung aus Polarisator und Analysator verwendet wird. Zwischen Polarisator und Analysator ist ein akustooptischer Modulator angeordnet, der mit einem Sinussignal beaufschlagt wird und dadurch das vom Polarisator einfallende polarisierte Licht, das von einer Lichtquelle durch einen Kondensor und eine Spaltblende auf den Polarisator projiziert wird, doppelt bricht. Das doppelt gebrochene Licht fällt auf den Analysator, der aus zwei Polarisatoren mit gegeneinander um 90° gedrehten Polarisationsebenen besteht. Eine der Polarisationsebenen fällt dabei mit der Polarisationsebene des dem Modulator vorgeordneten Polarisators zusammen. Im Analysator verursacht das doppelt gebrochene Licht eine Aufhellung der Dunkelgebiete und eine Abschwächung der Hellgebiete. Das Bild des Analysators wird mittels eine Objektivs in eine Meßebene projiziert, in welcher auch die Strichmarke angeordnet ist. In Abgleichstellung ist die Strichmarke mit der Trennkante in der Abbildung des Analysators deckungsgleich, und eine die Meßebene abtastende Meßvorrichtung zeigt ein Nullsignal an. Fallen Trennkante und Strichmarke nicht zusammen, so zeigt die Meßvorrichtung ein Maximum an.

Eine solche Anordnung dient ausschließlich zum Lokalisieren von Strichmarken und ist nicht als Meßgerät für physikalische Größen geeignet.

Der Erfindung liegt die Aufgabe zugrunde, ein Meßgerät der eingangs genannten Art zu schaffen, bei welchem die erfaßte Meßgröße ohne elektronische oder dem Verschleiß unterliegende mechanische Hilfsmittel direkt optisch angezeigt wird.

Die Aufgabe ist bei einem Meßgerät der im Oberbegriff des Anspruchs 1 genannten Art durch die Merkmale im Kennzeichenteil des Anspruchs 1 gelöst.

Bei dem erfindungsgemäßen Meßgerät wird in vorteilhafter Weise der bekannte Faraday-Effekt bei magnetooptischen Substanzen ausgenutzt. Beim Hindurchtreten des im Polarisator polarisierten Lichtes wird dessen Polarisationsebene entsprechend der Stärke eines am magnetooptischen Element in Lichtdurchtrittsrichtung anliegenden Magnetfeldes bis zu 45° gedreht, und zwar in Lichteinfallsrichtung gesehen im Rechtssinn, wenn die Feldrichtung des Magnetfeldes mit der Lichtdurchtrittsrichtung übereinstimmt, und im Linkssinn, wenn die Feldrichtung der Lichtdurchtrittsrichtung entgegengesetzt ist. Wird nunmehr der Analysator auf die gedrehte Polarisationsebene so eingestellt, daß Licht durch ihn hindurchtreten kann, so ist die Einstellung des Analysators ein direktes Maß für die Drehung der Polarisationsebene, die unmittelbar mittels des hindurchtretenden Lichtes sichtbar gemacht werden kann. Als Lichtquelle genügt dabei normalerweise Umgebungslicht, so daß im allgemeinen keine zusätzliche Lichtquelle erforderlich ist.

Das erfindungsgemäße Meßgerät hat den Vorteil, daß weder eine Zwischenwandlung der physikalischen Meßgröße in eine elektrische Größe erforderlich ist, bevor diese als optische Anzeige erkennbar wird, noch daß mechanisch geführte Anzeigeelemente vorhanden sind. Die physikalische Meßgröße, wie Stromstärke, Länge, Position, Füllstand oder sonstige Größe, die sich über ein Magnetfeld darstellen läßt, wird vielmehr unmittelbar in einen optischen Anzeigewert umgesetzt, der direkt, z. B. an einer festen oder beweglichen Skala, ablesbar ist. Das erfindungsgemäße Meßgerät ist äußerst robust, da mechanisch unempfindlich, und eignet sich zum Einsatz unter rauhen Betriebsbedingungen, auch in explosionsgefährdeter Umgebung. Da keine beweglichen mechanischen Bauteile vorhanden sind, ist es unempfindlich gegen Erschütterungen und zeigt langfristig keine materialbedingten Ermüdungserscheinungen. Das Meßgerät benötigt keine elektrische Energie. Der angezeigte Meßwert der physikalischen Meßgröße wird solange sichtbar gespeichert, bis ein neuer Meßwert erfaßt wird. Die Herstellung kann weitgehend automatisch erfolgen, wobei man sich die gesamte Palette an Technologien zunutze machen kann, die im Zusammenhang mit Herstellungsverfahren der Mikroelektronik bekannt ist. Die Auflösung des Gerätes ist sehr hoch und nur vom Aufwand bei der Herstellung des magnetooptischen Elements, d. h. bei der Erzeugung der Struktur des magnetooptischen Elements mit Hilfe fotografischer Verfahren oder Elektronenstrahllithografie, beschränkt. Das Meßgerät kann zur Messung aller physikalischen Größen verwendet werden, die sich irgendwie durch Magnetfelder darstellen lassen.

Eine vorteilhafte Ausführungsform der Erfindung ergibt sich aus Anspruch 2. Die Meßwertanzeige wird dabei vorteilhaft von hinten her durchleuchtet und weist auch bei geringer Umlichtstärke noch eine ausreichende Helligkeit auf.

Eine vorteilhafte Ausführungsform der Erfindung ergibt sich auch aus Anspruch 4. Mit einem solchermaßen aufgebauten magnetooptischen Element läßt sich das erfindungsgemäße Meßgerät zur Längenmessung, Positionsbestimmung und Temperaturmessung verwenden. Durch Anlegen entgegengesetzt gerichteter Magnetfelder an zwei benachbarten Domänen des magnetooptischen Elements und Einstellung des Analysators auf eine der beiden gedrehten Polarisationsebenen, wird das durch eine Domäne hindurchtretende Licht auch den Analysator durchdringen, während das durch die andere Domäne hindurchtretende Licht abgeschattet wird. Längs der Domänengrenze erscheint auf der Rückseite des Analysators bzw. auf einer hinter oder vor dem Analysator angeordneten Skala eine scharfe Hell-Dunkel-Kante, die eine ausgezeichnet ablesbare Anzeigemarke darstellt. Ist nunmehr noch die Skala mit einer geeignete Skalierung gemäß Anspruch 8 versehen, so läßt sich die Meßgröße direkt ablesen. Die rechtwinkelig zur Polarisationsebene sich erstreckende Abmessung der Domänen kann nahezu beliebig eingestellt werden, so daß man eine sehr hohe Auflösung von beispielsweise 1 mm erzielen kann. Die Domänen können entweder gemäß Anspruch 5 oder gemäß Anspruch 6 hergestellt werden. Als Material kommen dabei alle Substanzen in Frage, die einen ausgeprägten magnetooptischen Effekt aufweisen, also sog. magnetooptisch aktive Medien. Vorteilhaft ist gemäß Anspruch 7 die Verwendung von Granat als magnetooptische Substanz, die ggf. Beimengungen anderer Metalle, wie Yttrium oder Gadolinium, aufweisen kann.

Eine vorteilhafte Ausführungsform der Erfindung ergibt sich aus Anspruch 9. Oberhalb des Curiepunktes wirkt die Wärmebewegung der Moleküle ihrer Ausrichtung in einem magnetischen Feld entgegen, so daß der Faraday-Effekt nicht mehr auftritt. Wird nun gemäß Anspruch 9 der Curiepunkt der einzelnen Domänen mittels unterschiedlicher Beimengungen von Metallatomen in den einzelnen Domänen derart eingestellt, daß die Curiepunkte der einzelnen Domänen im Temperaturmeßbereich mit zunehmender Temperatur von der untersten zur obersten Domäne durchschritten werden, so wird der Lichtdurchtritt durch die Polarisationsanordnung wegen fehlender Drehung der Polarisationsebene von der unteren Domäne zur oberen hin mit zunehmender Temperatur unterbrochen. Es entsteht auf einer vor oder hinter dem Analysator angeordneten Skala ein oberer Hellbereich und ein unterer Dunkelbereich der längs einer Domänengrenze eine scharfe Trennungskante aufweist. Mit zunehmender Temperatur verschiebt sich die Trennungskante bei der beschriebenen Dotierung der Domänen nach oben.

Eine vorteilhafte Ausführungsform der Erfindung ergibt sich aus Anspruch 11, insbesondere in Verbindung mit Anspruch 12. Gegenüber den heute üblicherweise verwendeten Füllstandanzeigen hat das erfindungsgemäß als Füllstandmesser verwendete Meßgerät den Vorteil, sehr genau mit hohem Auflösungsvermögen zu messen und anzuzeigen, wobei der optische Eindruck einer ununterbrochenen Anzeige vermittelt wird. Zur Ansteuerung des magnetooptischen Elements sind nur geringe Feldstärken von etwa 380-760 A/m erforderlich. Dadurch können Schwimmer mit extrem leichtem Magnetfeldgenerator, z. B. kleinem Dauermagneten, verwendet werden und damit wiederum kleinere Schwimmer und kleinere Meßrohre. Neben technischen Vorteilen ergeben sich erhebliche Kosteneinsparungen. Außerdem bieten sich für die eigentliche Meßanordnung im Meßrohr neue Gestaltungsmöglichkeiten und größere Freiheiten in der konstruktiven Gestaltung des Meßrohrs nebst Inhalt. Insgesamt läßt sich durch verbesserte Ergonomie, erhöhte Genauigkeit und mechanische Unempfindlichkeit bei gleichzeitiger Systemverkleinerung ein geringerer Gesamtaufwand erzielen.

Eine vorteilhafte Ausführungsform der Erfindung ergibt sich aus Anspruch 13. Durch das von dem Dauermagneten erzeugte Magnetfeld werden die jeweils oberhalb und unterhalb der Magnetmitte liegenden Domänen von Magnetfeldbereichen mit entgegengerichteter Feldrichtung durchsetzt. Damit wird der hinter einer Gruppe von Domänen mit gleichgerichteter Magnetisierungsrichtung jeweils sich erstreckende Skalenbereich beleuchtet bzw. abgedunkelt. Die Magnetmitte stimmt dann mit dem momentanen Füllstand überein, der durch die Trennkante zwischen Hell-Dunkel-Bereich der Skala angezeigt wird.

Eine vorteilhafte Ausführungsform der Erfindung ergibt sich auch aus Anspruch 14. Bei dieser Ausbildung des Magnetfeldgenerators wird das magnetooptische Element von drei Magnetfeldbereichen durchsetzt, wobei der etwa mit der Scheibe fluchtende Bereich beidseitig von zwei Bereichen begrenzt wird, die jeweils gleiche aber dem mittleren Bereich entgegengerichtete Feldrichtung aufweisen. In diesem Fall wird vorteilhaft der Analysator auf die Polarisationsebenen-Drehung durch den mittleren Magnetfeldbereich eingestellt. Dadurch wird eine sehr schmale Zone der Skala beleuchtet, die eine den Füllstand kennzeichnete Strichmarkierung sichtbar macht und damit eine punktweise Anzeige ermöglicht.

Eine vorteilhafte Ausführungsform der Erfindung ergibt sich auch aus Anspruch 16. Mittels solcher Magnetfeldsensoren läßt sich in einfacher Weise eine elektrische Fernanzeige der Meßwerte realisieren. Solche Sensoren sind mit preiswerten Verfahrenstechniken auf oder in dem magnetooptischen Element selbst anbringbar.

Eine vorteilhafte Ausführungsform der Erfindung ergibt sich auch aus Anspruch 17. Solche Permalloy-Sensoren lassen sich entsprechend dem Raster der Domänen ausbilden, so daß die Auflösung bei einer solchen elektrischen Fernanzeige wesentlich höher ist, als dies mit bekannten Reedkontakt-Leisten möglich ist.

In explosionsgefährdeter Umgebung können aber auch optische Sensoren, wie Gabellichtschranken, eingesetzt werden.

Die Erfindung ist anhand eines in der Zeichnung dargestellten Ausführungsbeispiels eines als Füllstandmesser ausgebildeten Meßgeräts im folgenden näher beschrieben. Es zeigen jeweils in schematischer Darstellung :

Fig. 1 eine Seitenansicht eines Flüssigkeitsbehälters mit daran angeschlossenem Füllstandmesser,

Fig. 2 einen Querschnitt des Füllstandmessers gemäß Linie II-II in Fig. 1,

Fig. 3 einen vergrößerten Schnitt eines magnetooptischen Elements des Füllstandmessers in Fig. 1, ausschnittweise,

Fig. 4 eine vergrößerte perspektivische Ansicht von Polarisator, magnetooptischem Element, Analysator und Skalenträger des Füllstandmessers in Fig. 1, ausschnittweise, zur Erläuterung der Wirkungsweise,

Fig. 5 eine vergrößerte Seitenansicht eines Magnetfeldgenerators des Füllstandmessers in Fig. 1 mit angedeutetem Magnetfeld,

Fig. 6 und 7 jeweils eine vergrößerte Ansicht eines Skalenträgers des Füllstandmessers in Fig. 1, ausschnittweise,

Fig. 8 ein Blockschaltbild einer Schaltungsanordnung zur elektrischen Fernübertragung von Meßwerten.

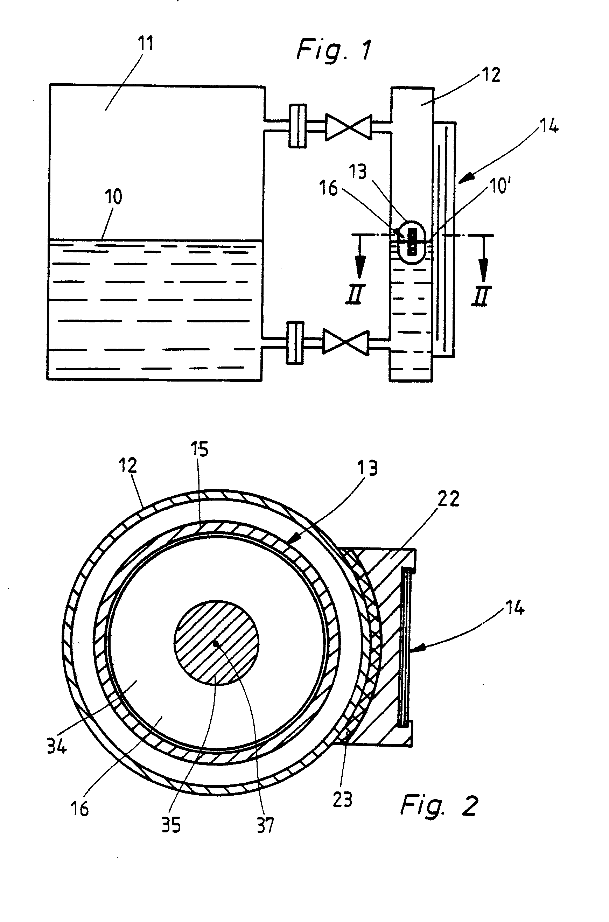

Mittels des in Fig. 1 und 2 dargestellten Füllstandmessers soll der in einem Flüssigkeitsbehälter 11 herrschende Flüssigkeitsspiegel 10 optisch angezeigt werden. Zu diesem Zweck ist ein Meßrohr 12 als Bypaß an dem Flüssigkeitsbehälter 11 angeschlossen, so daß nach dem Prinzip der kommunizierenden Röhren der Flüssigkeitsspiegel 10' im Meßrohr 12 das gleiche Niveau einnimmt. Die Lage des Flüssigkeitsspiegels 10' wird über einen Schwimmer 13 auf die Meß- und Anzeigevorrichtung 14 des Füllstandmessers übertragen. Zur Übertragung dient ein im Gehäuse 15 des Schwimmers angeordneter Magnetfeldgenerator 16, dessen Magnetfeld auf den Meßwertaufnehmer des Meßgerätes wirkt, der wiederum die Meßwertanzeige steuert. Der Magnetfeldgenerator 16 ist im einfachsten Fall als kleiner Dauermagnet ausgebildet, dessen Polachse sich in Hubrichtung des Schwimmers 13 bzw. Flüssigkeitsspiegels 10' erstreckt.

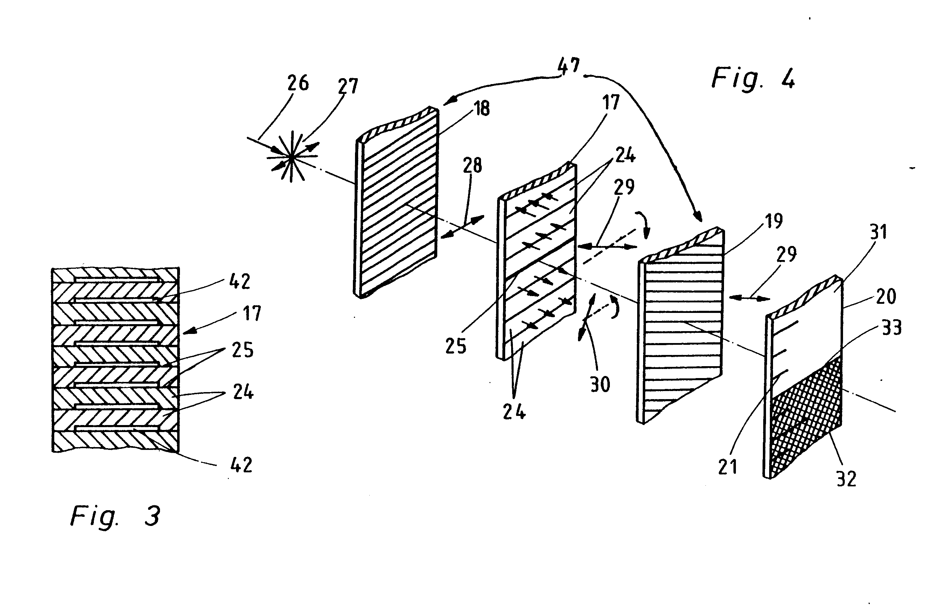

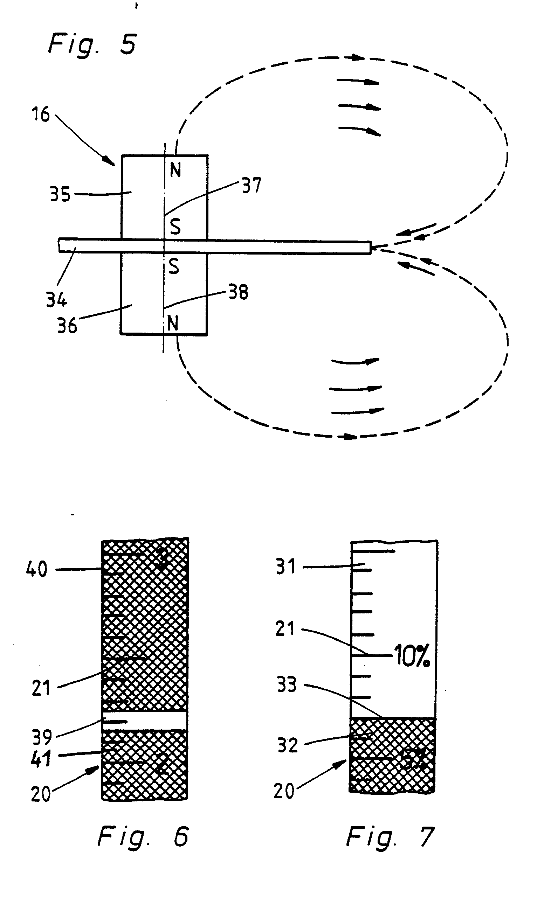

Der Meßwertaufnehmer und die Meßwertanzeige der Meß- und Anzeigevorrichtung 14 des Füllstandmessers werden von einem magnetooptischen Element 17 mit einer Polarisationsanordnung 47 gebildet. Letztere weist einen Polarisator 18 und einen Analysator 19 auf, jeweils in Lichteinfallsrichtung vor bzw. hinter dem Element 17 angeordnet. Hinter dem Analysator 19 ist ein transparenter Skalenträger 20 angeordnet, auf dem eine Skalierung 21 angebracht ist (Fig. 4). Solche Skalierungen 21 können — wie Fig. 6 und 7 zeigen — verschieden ausgebildet sein und mittels Aufdampfprozesse bzw. Ätztechniken problemlos auf den Skalenträger 20 aufgebracht werden. Es ist auch möglich, auf den Skalenträger 20 ganz zu verzichten und die Skalierungen 21 mit entsprechenden Verfahren auf der Rückseite des Analysators 19 oder des Elements 17 unmittelbar anzubringen.

Wie aus Fig. 2 ersichtlich ist, ist die Meß- und Anzeigevorrichtung 14 außen auf dem aus diamagnetischem Material bestehenden Meßrohr 12 aufgebracht. Zur Befestigung der Meß- und Anzeigevorrichtung 14 am Meßrohr 12 ist ein Träger 22 vorgesehen, der gleichzeitig als Lichtsammler ausgebildet ist. Der Träger 22 ist aus transparentem Kunststoff und weist eingeschlossene Fluoreszenzpartikel auf, so daß die Meßwertanzeige auch bei schwachem Umgebungslicht einwandfrei abzulesen ist. Zur Erzielung einer farbigen Gestaltung können die Fluoreszenzpartikel farbig sein. Zur Wärmeisolation ist zwischen der Wand des Meßrohrs 12 und der Unterseite des Trägers 22 eine isolierende Unterlage 23 angebracht.

Wie aus Fig. 3 hervorgeht ist das magnetooptische Element 17 aus einer Vielzahl von sog. Domänen 24, das sind Zonen mit jeweils einheitlicher Magnetisierungsrichtung, aufgebaut. Diese Domänen 24 sind in einer Ebene, die in etwa parallel ist zu der Ebene, in der sich der Polarisator 18 befindet, ausgerichtet und in Richtung der Normalen auf die Polarisationsebene 28 unmittelbar aneinandergereiht. Sie sind durch im wesentlichen gradlinig verlaufende, parallel zur Polarisationsebene (28) sich erstreckende scharfe Domänengrenzen 25 voneinander getrennt. In dem Ausführungsbeispiel sind die Domänen 24 aus einem Granatkristall mit Beimengungen anderer Metalle, wie Gadolinium oder Yttrium, hergestellt. Jede Domäne 24 besteht aus einem dünnen Plättchen, das aus einem sog. Einkristall geschnitten wird. Als Domänen 24 können aber auch im sog. Epitaxieverfahren aufgedampfte dünne Schichten zur Anwendung kommen. Der Polarisator 18, der Analysator 19 und der Skalenträger 20 erstrecken sich quer zu Lichteinfallsrichtung in Richtung der Normalen auf die Polarisationsebene 28 des Polarisators 18 über die gesamte Länge des aus den einzelnen Domänen 24 bestehenden magnetooptischen Elements 17, und die gesamte Meßanordnung 14 erstreckt sich über den maximalen Hub des Schwimmers bzw. des Magnetfeldgenerators 16, also letztlich über den Hubbereich des Flüssigkeitsspiegels 10' im Meßrohr 12. Die Skalierung 21 ist dabei so gewählt, daß die Skaleneinteilung der quer zur Lichteinfallsrichtung in Richtung der Normalen zur Polarisationsebenen 28 des Polarisators 18 sich erstreckenden Abmessung der Domänen 24 oder einem ganzzahligen Vielfachen davon entspricht.

In der Meß- und Anzeigevorrichtung 14 wird der bei magnetooptischen Substanzen bekannte Faraday-Effekt ausgenutzt. Dies sei kurz anhand der Fig. 4 erläutert.

Aus der Richtung 26 einfallendes, in beliebig vielen Polarisationsebenen schwingendes Licht 27 wird durch den Polarisator 18 in der Schwingungsrichtung oder Polarisationsebene 28 polarisiert, wie sie in Fig. 4 durch einen Pfeil symbolisch angedeutet ist. Zwei übereinanderliegende und durch die Domänengrenze 25 voneinander getrennte Gruppen von Domänen 24 werden mittels des von dem Magnetfeldgenerator 16 erzeugten Magnetfelds in entgegengesetzter Richtung magnetisiert, was in Fig. 4 durch Feldlinienpfeile angedeutet ist. Nach dem Faraday-Effekt wird dann die Polarisationsebene 28 des durch das magnetooptische Element 17 hindurchtretenden Lichtes bis zu 45° gedreht, und zwar in der oberen Domänengruppe in Lichteinfallsrichtung 26 gesehen im Linkssinn, also entgegen Uhrzeigersinn, und in der unteren Domänengruppe im Rechtssinn. Die Polarisationsebene des die obere Domänengruppe verlassenden Lichtes ist in Fig. 4 mit 29 gekennzeichnet, während die Polarisationsebene des die untere Domänengruppe verlassenden Lichtes mit 30 gekennzeichnet ist. Der Analysator 19 ist nunmehr so eingestellt, daß er nur Licht hindurchtreten läßt, das in der Polarisationsebene 29 schwingt. Für den Betrachter zeigt sich das in Fig. 4 dargestellte Bild des Skalenträgers 20, nämlich eine obere Hellzone 31 und eine untere Dunkelzone 32 mit einer scharfen Trennungslinie 33. Diese Trennungslinie 33 bildet sich immer dort aus, wo Domänen 24 mit entgegengesetzter Feldrichtung aneinanderstoßen. Die Magnetisierung der Domänen 24 bleibt solange erhalten, bis entweder der Curiepunkt überschritten wird oder ein entgegengesetztes Magnetfeld an die betreffende Domäne 24 gelegt wird. Damit bleibt der Meßwert, der durch die Trennungslinie 33 an der Skalierung 21 ablesbar ist, auf lange Zeit gespeichert, und zwar solange, bis der nächste demgegenüber veränderte Meßwert angezeigt wird. Die beiden Magnetfelder mit im wesentlichen in Lichteinfallsrichtung 26 sich erstreckenden aber antiparallelen Magnetisierungsrichtungen werden von dem Magnetfeldgenerator 16 erzeugt. Die beschriebene obere Hellzone 31 und untere Dunkelzone 32 mit Trennungslinie 33 (Fig. 4 und 7), ergibt sich bei Ausbildung des Magnetfeldgenerators 16 als kleiner Permanentmagnet, dessen Polachse in Hubrichtung ausgerichtet ist. Die Trennungslinie 33 liegt dann etwa in Höhe der Magnetmitte und zeigt damit das Niveau des Flüssigkeitsspiegels 10' an. Verschiebt sich dieses, so wandert die Trennungslinie 33 an der Skalierung 21 entsprechend nach oben oder unten.

Wie aus Fig. 5 und Fig. 2 ersichtlich, kann der Magnetfeldgenerator 16 auch aus zwei in entgegengesetzter Richtung von einer ferromagnetischen Scheibe 34 im wesentlichen rechtwinklig abstehenden Dauermagneten 35, 36 gebildet sein, wobei die Polachsen 37, 38 der Dauermagnete 35, 36 fluchten. Die Dauermagnete 35, 36 weisen gleiche Abmessungen auf, und die Polachsen 37, 38 sind antiparallel ausgerichtet, so daß die Nordpole der Dauermagnete 35 und 36 an den freien Enden und die Südpole an der Scheibe 34 liegen. Das von diesem Magnetfeldgenerator 16 ausgebildete Magnetfeld ist in Fig. 5 strichliniert symbolisch dargestellt. Das magnetooptische Element 17 wird in einem gewissen Bereich oberhalb und unterhalb des momentanen Flüssigkeitsspiegels 10', d. h. der momentanen Lage des Schwimmers 13 und damit des Magnetfeldgenerators 16, von insgesamt drei Magnetfeldbereichen parallel zur Lichteinfallsrichtung durchsetzt. Eine mittlere, mit der Scheibe 34 im wesentlichen fluchtende Zone des magnetooptischen Elements 17 wird von einem Magnetfeldbereich durchsetzt, dessen Feldrichtung der Lichteinfallsrichtung 26 entgegengesetzt gerichtet ist. Die daran sich anschließenden oberen und unteren Bereiche des magnetooptischen Elements 17 werden von Magnetfeldbereichen durchsetzt, deren Magnetisierungsrichtung gleich ist, aber der des mittleren Magnetfeldbereiches entgegengesetzt. Bei dieser Festlegung der Magnetfeldrichtungen am magnetooptischen Element 17 wird die Polarisationsebene 28 des durch das Magnetooptische Element 17 hindurchtretenden Lichtes wie beschrieben gedreht, und zwar in den äußeren Domänengruppen in Lichteinfallsrichtung gesehen im Rechts- oder Uhrzeigersinn und in der mittleren, sehr viel kleineren und meist nur wenige Domänen 24 umfassenden Domänengruppe im Linkssinn. Der Analysator 19 läßt wiederum nur Licht, welches in der Polarisationsebene 29 schwingt, hindurch. Auf dem Skalenträger 21 entsteht ein optischer Eindruck wie er in Fig. 6 dargestellt ist, und zwar erscheint auf der Skalierung 21 eine mittlere sehr schmale Hellzone 39, die beidseitig von ausgestreckten Dunkelbereichen 40 bzw. 41 begrenzt ist. Diese sehr schmale Hellzone 39 bildet die Anzeigemarke, die ein Ablesen des momentanen Flüssigkeitsniveaus an der Skalierung 21 erlaubt.

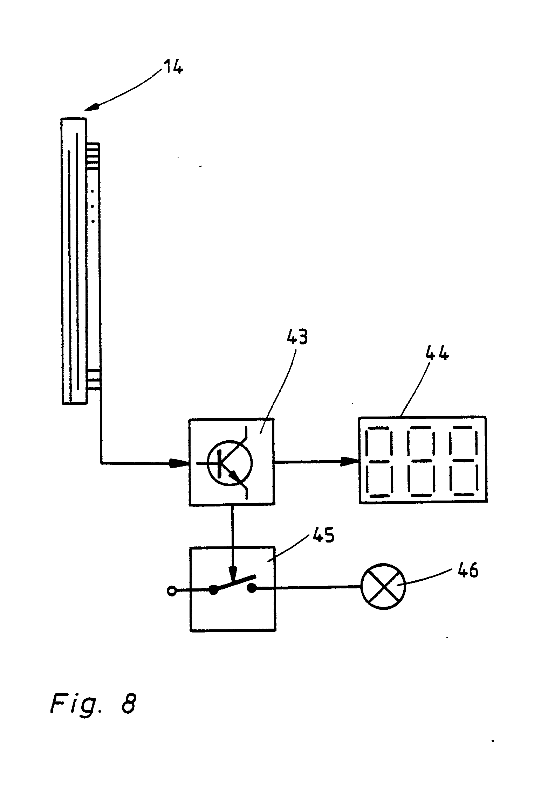

In vielen Fällen ist eine elektrische Fernanzeige der an der Skalierung sichtbaren Meßwerte erwünscht. Bei explosionsgefährdeter Umgebung können z. B. optische Sensoren, wie Gabellichtschranken verwendet werden, die die Anzeigewerte optisch abtasten und als elektrische Signale an eine Auswerteschaltung geben. In dem beschriebenen Ausführungsbeispiel sind hingegen sog. Magnetfeldsensoren verwendet, die als Permalloy-Schichten 42 (Fig. 3), das sind Eisen-Nickel-Legierungen mit besonders hoher magnetischer Suszeptibilität, ausgebildet sind. Diese mit elektrischen Anschlüssen versehenen Permalloy-Schichten 42 sind innerhalb der Domänen 24 angeordnet, wobei ihre Abmessungen kleiner sind als die der Domänen 24. Diese Permalloy-Schichten 42 können ebenfalls durch Aufdampfen bei der Herstellung des magnetooptischen Elements 17 erzeugt werden. Die elektrischen Signalausgänge der Permalloy-Schichten 42 sind — wie in Fig. 8 schematisch angedeutet — mit einer Auswertelogik 43 verbunden, die einerseits eine digitale Meßwertanzeige 44 und andererseits eine Grenzwertanzeige 45 mit Warnlampe 46 steuert. Anstelle der Warnlampe 46 können auch Ventile oder Pumpen angesteuert werden. Da eine Permalloy-Schicht 42 in jeder Domäne 24 vorhanden sein kann, läßt sich eine dem Raster der Domänen entsprechende Auflösung bei der Fernanzeige erreichen. Diese Auflösung ist höher als sie heute mit bekannten Reedleisten realisiert werden kann.

Die Erfindung ist nicht auf das vorstehend beschriebene Ausführungsbeispiel des Meßgeräts als Füllstandmesser beschränkt. So kann dieses Meßgerät mit allen beschriebenen Vorteilen überall dort angewendet werden, wo sich die zu messende physikalische Größe in irgendeiner Art und Weise über ein Magnetfeld darstellen läßt. Dies gilt z. B. sowohl für Längenmessung als auch für Stromstärkemessung als auch für Temperaturmessung. Das als Thermometer ausgebildete Meßgerät wurde eingangs bereits beschrieben und beruht auf der Tatsache, daß die magnetische Ausrichtung der Domänen 24 bei Überschreiten des Curiepunktes aufgehoben wird. Werden die Domänen 24 durch Anlegen eines magnetischen Feldes in gleicher Richtung magnetisiert und sind die Domänen so eingestellt, daß der Curiepunkt aufeinanderfolgender Domänen mit zunehmender Temperatur überschritten wird, so läßt sich in sehr einfacher Weise ein Temperaturmeßgerät realisieren.

Weiterhin braucht bei dem beschriebenen Füllstandmesser der Magnetfeldgenerator 16 nicht an dem Schwimmer 13 beweglich und die Meß- und Anzeigevorrichtung 14 nicht feststehend am Meßrohr 12 angeordnet zu sein. Da es nur auf die Relativbewegung zwischen beiden Baugruppen ankommt, ist eine Vertauschung ohne weiteres möglich. Wird jedoch die Meß- und Anzeigevorrichtung 14 auf dem Schwimmer angeordnet, so sollte dieser eine künstliche Lichtquelle zugeordnet werden, um eine einwandfreie Ablesung zu gewährleisten.

Auch kann der Skalenträger 20 zwischen dem Analysator 19 und dem magnetooptischen Element 17 angeordnet sein. Ein Verzicht auf den Skalenträger 20 und die Anbringung der Skalierung 21 unmittelbar auf dem Analysator 19 oder dem magnetooptischen Element 17 ist möglich.

**Patentansprüche**

1. Meßgerät zum Messen physikalischer Größen, wie Längen, Winkel, Positionen, Temperatur, elektrischer Strom, Füllstand, mit einem Meßwertaufnehmer und einer von diesem gesteuerten Meßwertanzeige, dadurch gekennzeichnet, daß Meßwertaufnehmer und Meßwertanzeige von einem mit einer Polarisationsanordnung (47) zusammenwirkenden magnetooptischen Element (17) gebildet sind.

2. Meßgerät nach Anspruch 1, dadurch gekennzeichnet, daß das magnetooptische Element (17) mit der Polarisationsanordnung (47) auf einem als Lichtsammler ausgebildeten Träger (22) angeordnet ist, in welchem vorzugsweise Fluoreszenzpartikel eingegossen sind.

3. Meßgerät nach Anspruch 1 oder 2, dadurch gekennzeichnet, daß die Polarisationsanordnung (47) einen Polarisator (18) und einen Analysator (19) aufweist und daß — in Lichteinfallsrichtung (26) gesehen — der Polarisator (18) vor und der Analysator (19) hinter dem magnetooptischen Element (17) angeordnet ist.

4. Meßgerät nach Anspruch 3, dadurch gekennzeichnet, daß das magnetooptische Element (17) eine Vielzahl von Domänen (24) genannten Zonen mit jeweils einheitlicher Magnetisierungsrichtung aufweist, die in einer Ebene liegen, die in etwa parallel zu der Ebene ist, in der der Polarisator (18) liegt und die in Richtung der Normalen zur Polarisationsebene (28) des Polarisators (18) unmittelbar aneinander gereiht und durch im wesentlichen scharfe, parallel zur Polarisationsebene (28) des Polarisators (18) sich erstreckende Domänengrenzen (25) voneinander getrennt sind, und daß der Polarisator (18) und der Analysator (19) sich jeweils über die sich durch Aneinanderreihung der Domänen (24) ergebende Länge des magnetooptischen Elements (17) erstrecken.

5. Meßgerät nach Anspruch 4, dadurch gekennzeichnet, daß die Domänen (24) von aus einem Einkristall geschnittenen dünnen Plättchen gebildet sind.

6. Meßgerät nach Anspruch 4, dadurch gekennzeichnet, daß die Domänen (24) von im Epitaxieverfahren aufgedampften dünnen Schichten gebildet sind.

7. Meßgerät nach einem der Ansprüche 4-6, dadurch gekennzeichnet, daß die Domänen (24) aus Granat, ggf. mit Beimengungen anderer Metalle, wie Gadolinium oder seltenen Erden, bestehen.

8. Meßgerät nach einem der Ansprüche 4-7, dadurch gekennzeichnet, daß in Lichteinfallsrichtung vor oder hinter dem Analysator (19) eine Skalierung (21) angebracht ist und daß die Skaleneinteilung vorzugsweise der in Richtung der Normalen zur Polarisationsebene (28) des Polarisators (18) sich erstreckenden Abmessung der Domänen (24) oder einem ganzzahligen Vielfachen davon entspricht.

9. Meßgerät nach einem der Ansprüche 4-8, dadurch gekennzeichnet, daß zum Zwecke seiner Verwendung als Thermometer die Domänen (24) aus Granat mit unterschiedlichen Beimengungen von seltenen Erden bestehen, derart, daß der Curiepunkt aufeinanderfolgender Domänen (24) monoton zu- oder abnimmt.

10. Meßgerät nach einem der Ansprüche 4-8, gekennzeichnet durch seine Verwendung als Füllstandmesser für Flüssigkeitsbehälter (11).

11. Meßgerät nach Anspruch 10, dadurch gekennzeichnet, daß im Flüssigkeitsbehälter (11) oder in einem mit diesem kommunizierenden Meßrohr (12) ein flüssigkeitsumspülter Schwimmer (13) mit einem Magnetfeldgenerator (16) vorgesehen ist und daß das magnetooptische Element (17) und die Polarisationsanordnung (47) sich über mindestens einen Teilhubweg des Magnetfeldgenerators (16), vorzugsweise über dessen maximalen Hubweg, erstrecken.

12. Meßgerät nach Anspruch 11, dadurch gekennzeichnet, daß die Polarisationsebene (28) des Polarisators (18) und die Domänengrenzen (25) des magnetooptischen Elements (17) horizontal ausgerichtet sind und daß der Magnetfeldgenerator (16) derart ausgebildet ist, daß in mindestens einem Teilbereich der Längserstreckung des magnetooptischen Elements (17) zwei einander entgegengesetzte, in Lichteinfallsrichtung (26) sich erstreckende magnetische Feldrichtungen auftreten, die ober- und unterhalb einer Domänengrenze (25) verlaufen.

13. Meßgerät nach Anspruch 12, dadurch gekennzeichnet, daß der Magnetfeldgenerator (16) als ein sich in Hubrichtung erstreckender stabförmiger Dauermagnet ausgebildet ist.

14. Meßgerät nach Anspruch 12, dadurch gekennzeichnet, daß der Magnetfeldgenerator (16) zwei auf gegenüberliegenden Seiten einer ferromagnetischen Scheibe (34) von dieser in deren Achsrichtung abstehende Dauermagnete (35, 36) mit vorzugsweise gleichen Abmessungen aufweist, deren Polachsen in Hubrichtung des Magnetfeldgenerators (16) ausgerichtet sind und vorzugsweise miteinander fluchten und deren Magnetisierungsrichtungen einander entgegengesetzt sind.

15. Meßgerät nach einem der Ansprüche 11-14, dadurch gekennzeichnet, daß der zur Aufnahme des Magnetfeldgenerators (16) hohl ausgebildete Schwimmer (13) und das Meßrohr (12) aus einem diamagnetischen Werkstoff bestehen.

16. Meßgerät nach einem der Ansprüche 10-15, dadurch gekennzeichnet, daß im oder am magnetooptischen Element (17) zum Zwecke einer elektrischen Fernanzeige Magnetfeldsensoren (42) vorgesehen sind, deren elektrische Anschlüsse mit einer Auswertelogik (43) verbunden sind.

17. Meßgerät nach Anspruch 16, dadurch gekennzeichnet, daß in jeder Domäne (24) ein vorzugsweise als Permalloy-Schicht (42) ausgebildeter Magnetfeldsensor vorgesehen ist.

## Claims

1. Measuring device for the measuring of physical values, such as lengths, angles, positions, temperature, electrical current, filled level, comprising a measurand pick-up and a measurand indicator controlled by it, characterized in that measured pick-up and measurand indicator are formed of a magnetooptical element (17), cooperating with a polarisation assembly (47).

2. Measuring device according to Claim 1, characterized in that the magnetooptical element (17) is disposed with the polarization assembly (47) on a support (22) constructed as a light collector, in which support preferably fluorescent particles are cast in.

3. Measuring device according to Claim 1 or 2, characterized in that the polarization assembly (47) comprises a polarizer (18) and an analyser (19) and that, as viewed in the direction (26) of incident light, the polarizer (18) is disposed before the magnetooptical element (17) and the analyser (19) is disposed behind the magnetooptical element (17).

4. Measuring device according to Claim 3, characterized in that the magnetooptical element (17) comprises a plurality of zones termed domains (24), each having a consistent magnetization direction, which domains lie in a plane which is approximately parallel to the plane in which the polarizer (18) lies, and which are arranged in a row in the direction of the perpendiculars to the polarization plane (28) of the polarizer (18) and directly adjacent to each other and are separated from one another by substantially sharp domain boundaries (25), extending parallel to the polarization plane (28) of the polarizer (18), and that the polarizer (18) and the analyser (19) each extend over the length of the magnetooptical element (17) given by the arranging of the domains (24) in a row.

5. Measuring device according to Claim 4, characterized in that the domains (24) are formed of thin platelets cut from a monocrystal.

6. Measuring device according to Claim 4, characterized in that the domains (24) are formed of thin layers vapour-deposited in the epitaxy process.

7. Measuring device according to one of Claims 4 to 6, characterized in that the domains (24) are formed of garnet, optionally with admixtures of other metals, such as gadolinium or rare earths.

8. Measuring devices according to one of Claims 4 to 7, characterized in that, as viewed in the direction of incident light, a scale marking (21) is applied before or behind the analyser (19), and that the scale division preferably corresponds to the dimension of the domains (24) or a whole-number multiple thereof, extending in the direction of the perpendiculars to the polarization plane (28) of the polarizer (18).

9. Measuring device according to one of Claims 4 to 8, characterized in that, for the purpose of its use as a thermometer, the domains (24) are of garnet comprising different admixtures of rare earths, in such a manner that the Curie point of successive domains (24) increases or decreases monotonously.

10. Measuring device according to one of Claims 4 to 8, characterized by its use as a filled level meter for liquid containers (11).

11. Measuring device according to Claim 10, characterized in that, in the liquid container (11) or in a measuring tube (12) communicating with it, a float (13) flushed around by liquid and having a magnetic field generator (16) is provided, and that the magnetooptical element (17) and the polarization assembly (47) extend over at least part of the stroke travel of the magnetic field generator (16), preferably over its maximum stroke travel.

12. Measuring device according to Claim 11, characterized in that the polarization plane (28) of the polarizer (18) and the domain boundaries (25) of the magnetooptical element (17) are orientated horizontally and that the magnetic field generator (16) is so constructed that, in at least one partial zone of the longitudinal extent of the magnetooptical element (17), two mutually opposed magnetic field directions, orientated in the direction (26) of the incident light, are present, which extend above and below a domain boundary (25).

13. Measuring device according to Claim 12, characterized in that the magnetic field generator (16) is constructed as a bar-shaped permanent magnet extending in the direction of stroke.

14. Measuring device according to Claim 12, characterized in that the magnetic field generator (16) possesses two permanent magnets (35, 36) projecting on opposite sides of a ferromagnetic disc (34) from this disc in their axial direction and preferably having the same dimensions, the pole axes of which are orientated in the stroke direction of the magnetic field generator (16) and preferably are aligned with each other, and the magnetizing directions of which are opposed to each other.

15. Measuring device according to one of Claims 11 to 14, characterized in that the float (13), constructed hollow for seating the magnetic field generator (16), and the measuring tube (12) are of a diamagnetic material.

16. Measuring device according to one of Claims 10 to 15, characterized in that in or on the magnetooptical element (17), for the purpose of an electrical remote indication, magnetic field sensors (42) are provided, the electrical terminals of which are connected with an evaluating logic (43).

17. Measuring device according to Claim 16, characterized in that, in each domain (24), a magnetic field sensor preferably constructed as a permalloy layer (42) is provided.

**Revendications**

1. Appareil de mesure en vue de mesurer des grandeurs physiques telles que des longueurs, des angles, des positions, des températures, des courants électriques et des niveaux, cet appareil comportant un releveur des valeurs de mesure et une unité d'affichage des valeurs de mesure, commandée par ce dernier, caractérisé en ce que le releveur et l'unité d'affichage des valeurs de mesure sont formés par un élément magnéto-optique (17) coopérant avec un système de polarisation (47).

2. Appareil de mesure selon la revendication 1, caractérisé en ce que l'élément magnéto-optique (17) est disposé, avec le système de polarisation (47), sur un support (22) réalisé sous forme d'un collecteur de lumière et dans lequel sont enfermées, de préférence, des particules de matière fluorescente.

3. Appareil de mesure selon la revendication 1 ou 2, caractérisé en ce que le système de polarisation (47) comporte un polariseur (18) et un analyseur (19) tandis que, vu dans le sens d'incidence (26) de la lumière, le polariseur (18) est disposé devant l'élément magnéto-optique (17) et l'analyseur (19), derrière ce dernier.

4. Appareil de mesure selon la revendication 3, caractérisé en ce que l'élément magnéto-optique (17) comporte plusieurs domaines (24) de zones mentionnées ayant chacun un sens de magnétisation cohérent et situés dans un plan qui est à peu près parallèle au plan dans lequel est situé le polariseur (18), ces domaines se succédant immédiatement dans le sens de la perpendiculaire au plan de polarisation (28) du polariseur (18), tandis qu'ils sont séparés l'un de l'autre par des limites très nettes (25) s'étendant parallèlement au plan de polarisation (28) du polariseur (18), le polariseur (18) et l'analyseur (19) s'étendant chacun sur la longueur de l'élément magnéto-optique (17) résultant de la succession des domaines (24).

5. Appareil de mesure selon la revendication 4, caractérisé en ce que les domaines (24) sont formés par de minces plaquettes découpées hors d'un monocristal.

6. Appareil de mesure selon la revendication 4, caractérisé en ce que les domaines (24) sont formés par des couches minces appliquées selon la technique de métallisation sous vide dans un procédé d'épitaxie.

7. Appareil de mesure selon une des revendications 4 à 6, caractérisé en ce que les domaines (24) sont constitués de grenat, éventuellement avec des additions d'autres métaux tels que le gadolinium ou les terres rares.

8. Appareil de mesure selon une des revendications 4 à 7, caractérisé en ce que, vu dans le sens d'incidence de la lumière, des graduations (21) sont appliquées devant ou derrière l'analyseur (19), tandis que la division de l'échelle correspond, de préférence, à la dimension des domaines (24) s'étendant dans le sens de la perpendiculaire au plan de polarisation (28) du polariseur (18), ou à un multiple entier de cette dimension.

9. Appareil de mesure selon une des revendications 4 à 8, caractérisé en ce que, en vue de l'utiliser comme thermomètre, les domaines (24) sont constitués de grenat avec des additions différentes de terres rares de telle sorte que le point de Curie de domaines successifs (24) soit élevé ou abaissé selon une fonction monotone.

10. Appareil de mesure selon une des revendications 4 à 8, caractérisé en ce qu'on l'utilise comme indicateur de niveau pour un récipient de liquide (11).

11. Appareil de mesure selon la revendication 10, caractérisé en ce que, dans le récipient de liquide (11) ou dans un tube de mesure (12) communiquant avec ce récipient, on prévoit un flotteur (13) entouré de liquide et pourvu d'un générateur de champ magnétique (16), tandis que l'élément magnéto-optique (17) et le système de polarisation (47) s'étendent au moins sur une course d'élévation partielle du générateur de champ magnétique (16), de préférence, sur sa course d'élévation maximale.

12. Appareil de mesure selon la revendication 11, caractérisé en ce que le plan de polarisation (28) du polariseur (18) et les limites (25) des domaines de l'élément magnéto-optique (17) sont orientés horizontalement, tandis que le générateur de champ magnétique (16) est réalisé de telle sorte que, du moins dans une partie de la longueur sur laquelle s'étend l'élément magnétooptique (17), on obtienne deux directions de champ magnétique mutuellement opposées, s'étendant dans le sens d'incidence (26) de la lumière, au-dessus et en dessous d'une limite (25) de domaines.

13. Appareil de mesure selon la revendication 12, caractérisé en ce que le générateur de champ magnétique (16) est réalisé à la manière d'un aimant permanent sous forme de barre s'étendant dans le sens d'élévation.

14. Appareil de mesure selon la revendication 12, caractérisé en ce que le générateur de champ magnétique (16) comporte deux aimants permanents (35, 36) ressortant, dans leur sens axial, des faces opposées d'un disque ferromagnétique (34) et ayant, de préférence, les mêmes dimensions, tandis que leurs axes polaires sont orientés dans le sens d'élévation du générateur de champ magnétique (16) et sont, de préférence, mutuellement affleurants, leurs sens de magnétisation étant mutuellement opposés.

15. Appareil de mesure selon une des revendications 11 à 14, caractérisé en ce que le flotteur (13) de type creux destiné à recevoir le générateur de champ magnétique (16), de même que le tube de mesure (12) sont réalisés en une matière première diamagnétique.

16. Appareil de mesure selon une des revendications 10 à 15, caractérisé en ce que, dans ou sur l'élément magnéto-optique (17), en vue d'assurer un affichage électrique à distance, on prévoit des capteurs de champ magnétique (42) dont les connexions électriques sont raccordées à un circuit logique d'interprétation (43).

17. Appareil de mesure selon la revendication 16, caractérisé en ce que, dans chaque domaine (24), on prévoit un capteur de champ magnétique réalisé, de préférence, sous forme d'une couche de Permalloy (42).

Fig. 1

Fig. 2

1

Fig. 4

Fig. 3

0 145 856

Fig. 5

16

35

37

N

S

34

S

36

38

N

40

21

39

41

20

Fig. 6

31

21

10%

33

32

20

Fig. 7

Fig. 8